# EUROPEAN PATENT APPLICATION

(11) **EP 4 723 854 A1**
(43) Date of publication of application: **08.04.2026**
(21) Application number: 25191820.7
(22) Date of filing: 25.07.2025
(51) Int. Cl.: H10K 59/131, H10K 59/80, G09G 3/3233

(54) **DISPLAY DEVICE INCLUDING POWER SUPPLY LINE**

(30) Priority: 02.10.2024 KR 20240133707
(71) Applicant: LG Display Co., Ltd., Seoul, 07336 (KR)
(72) Inventor: BAE, Hyun-Jik, 10845 Paju-si (KR); KO, In-Tae, 10845 Paju-si (KR)
(74) Representative: Viering, Jentschura & Partner mbB Patent- und Rechtsanwälte

(57) **Abstract**

A display device (110) includes: a display panel (128) having a display area (DA) and a non-display area (NDA) at a periphery of the display area (DA); a plurality of gate lines (GL) and a plurality of data lines (DL) in the display area (DA), the plurality of gate lines (GL) and the plurality of data lines (DL) crossing each other to define a plurality of subpixels (SP1, ..., SP4); a pixel circuit unit (PC) in each of the plurality of subpixels (SP1, ..., SP4); an auxiliary circuit unit (AC) in the non-display area (NDA); and at least one power supply line (SLr, SLd, SLs) in the non-display area (NDA) and overlapping the auxiliary circuit unit (AC).

## Description

### Field of the Disclosure

The present disclosure relates to a display device, and more particularly, to a display device including a power supply line.

### Description of the Background

Recently, various flat panel display devices such as a liquid crystal display device (LCD), an organic light emitting diode (OLED) display device and a field emission display (FED) device having excellent properties of a thin profile, a light weight and a low power consumption have been developed and applied to various fields.

A display device includes a display panel displaying an image and a driving unit supplying a signal and a power to the display panel, and the driving unit includes a gate driving unit and a data driving unit supplying a gate voltage and a data voltage, respectively, to each pixel of the display panel.

The display device further includes a plurality of power lines in a non-display area for supplying a plurality of power voltages such as a reference signal, a high level signal and a low level signal.

However, an area of the non-display area increases due to the plurality of power lines, and it becomes difficult to obtain a narrow bezel.

### SUMMARY

Accordingly, the present disclosure is directed to a display device that substantially obviates one or more of the problems due to limitations and disadvantages of the related art.

More specifically, the present disclosure is to provide a display device where an area of a non-display area is reduced, a narrow bezel is obtained and a fabrication process is optimized by forming a plurality of power supply lines having the same layer and the same material as a bridge pattern for sensing a touch to overlap an auxiliary circuit unit.

Additional features and advantages of the disclosure will be set forth in the description which follows, and in part will be apparent from the description, or may be learned by practice of the disclosure. These and other advantages of the disclosure will be realized and attained by the structure particularly pointed out in the written description and claims hereof as well as the appended drawings.

To achieve these and other advantages and in accordance with the purpose of the present disclosure, as embodied and broadly described herein, a display device according to claim 1 is provided. Further embodiments are described in the dependent claims. According to various embodiments, a display device includes: a display panel having a display area and a non-display area at a periphery of the display area; a plurality of gate lines and a plurality of data lines in the display area, the plurality of gate lines and the plurality of data lines crossing each other to define a plurality of subpixels; a pixel circuit unit in each of the plurality of subpixels; an auxiliary circuit unit in the non-display area; and at least one power supply line in the non-display area and overlapping the auxiliary circuit unit.

The display device may further comprise: at least one power base line in the non-display area and connected to the at least one power supply line; and a plurality of bridge patterns and a plurality of sensor patterns in the display area for sensing a touch.

The at least one power supply line may have a same layer and a same material as the plurality of bridge patterns.

The auxiliary circuit unit may include at least one of a plurality of multiplexers and a plurality of electrostatic discharge circuits.

The at least one power base line may include a reference base line in the non-display area at an upper portion of the display area, a high level base line in the non-display area at a lower portion of the display area and a low level base line in the non-display area at a lower portion of the high level base line, and the at least one power supply line may include a reference supply line overlapping the auxiliary circuit unit and connected to the reference base line, a high level supply line connected to the high level base line and a low level supply line connected to the low level base line.

The pixel circuit unit may include at least one thin film transistor, wherein the at least one thin film transistor may include a semiconductor layer, a gate insulating layer on the semiconductor layer, a gate electrode on the gate insulating layer corresponding to the semiconductor layer, first and second interlayer insulating layers on the gate electrode and a source electrode and a drain electrode on the second interlayer insulating layer, and wherein the reference base line, the high level base line and the low level base line may have a same layer and a same material as the source electrode and the drain electrode.

The display device may comprise a plurality of reference power lines, a plurality of high level power lines and a plurality of low level power lines spaced apart and parallel to the plurality of data lines and having a same layer and a same material as the gate electrode.

The plurality of reference power lines may be connected to the reference base line, the plurality of high level power lines may be connected to the high level base line, and the plurality of low level power lines may be connected to the low level base line.

First, second and third encapsulating layers may be disposed between the auxiliary circuit unit and the reference base line, and the first and third encapsulating layers may be disposed between the high level base line and the high level supply line and between the low level base line and the low level supply line.

The display device may further comprise first and second dams between the auxiliary circuit unit and the high level base line and a third dam between the high level base line and the low level base line.

It is to be understood that both the foregoing general description and the following detailed description are explanatory and are intended to provide further explanation of the disclosure as claimed.

### BRIEF DESCRIPTION OF THE DRAWINGS

The accompanying drawings, which are included to provide a further understanding of the disclosure and are incorporated in and constitute a part of this specification, illustrate embodiments of the disclosure and together with the description serve to explain the principles of the disclosure.

In the drawings:
FIG. 1 is a view showing a display device according to an embodiment of the present disclosure;
FIG. 2 is a circuit diagram showing a subpixel of a display device according to an embodiment of the present disclosure;
FIG. 3 is a cross-sectional view showing a subpixel of a display panel of a display device according to an embodiment of the present disclosure;
FIG. 4 is a plan view showing a display panel of a display device according to an embodiment of the present disclosure; and
FIG. 5 is a cross-sectional view taken along a line V-V of FIG. 4.

### DETAILED DESCRIPTION

Advantages and features of the present disclosure, and implementation methods thereof will be clarified through following example aspects described with reference to the accompanying drawings. The present disclosure may, however, be embodied in different forms and should not be construed as limited to the example aspects set forth herein. Rather, these example aspects are provided so that this disclosure may be sufficiently thorough and complete to assist those skilled in the art to fully understand the scope of the present disclosure. Further, the present disclosure is only defined by scopes of claims.

The shapes, sizes, ratios, angles, numbers, and the like, which are illustrated in the drawings to describe various example aspects of the present disclosure, are merely given by way of example. Therefore, the present disclosure is not limited to the illustrations in the drawings. Like reference numerals refer to like elements throughout the specification, unless otherwise specified.

In the following description, where the detailed description of the relevant known function or configuration may unnecessarily obscure a feature or aspect of the present disclosure, a detailed description of such known function or configuration may be omitted or a brief description may be provided.

Where the terms "comprise," "have," "include," and the like are used, one or more other elements may be added unless the term, such as "only," is used. An element described in the singular form is intended to include a plurality of elements, and vice versa, unless the context clearly indicates otherwise.

In construing an element, the element is to be construed as including an error or a tolerance range even where no explicit description of such an error or tolerance range is provided.

Where positional relationships are described, for example, where the positional relationship between two parts is described using "on," "over," "under," "above," "below," "beside," "next," or the like, one or more other parts may be located between the two parts unless a more limiting term, such as "immediate(ly)," "direct(ly)," or "close(ly)" is used. For example, where an element or layer is disposed "on" another element or layer, a third layer or element may be interposed therebetween.

Although the terms "first," "second," A, B, (a), (b), and the like may be used herein to refer to various elements, these elements should not be interpreted to be limited by these terms as they are not used to define a particular order or precedence. These terms are only used to distinguish one element from another. For example, a first element could be termed a second element, and, similarly, a second element could be termed a first element, without departing from the scope of the present disclosure.

The term "at least one" should be understood to include all combinations of one or more of related elements. For example, the term of "at least one of first, second and third elements" may include all combinations of two or more of the first, second and third elements as well as the first, second or third element.

The term "display device" may include a display device in a narrow sense such as liquid crystal module (LCM), an organic light emitting diode (OLED) module and a quantum dot (QD) module including a display panel and a driving unit for driving the display panel. In addition, the term "display device" may include a complete product (or a final product) including the LCM, the OLED module or the QD module such as a notebook computer, a television, a computer monitor, an equipment display device including an automotive display apparatus or a shape other than a vehicle, and a set electronic apparatus or a set device (or a set apparatus) such as a mobile electronic apparatus of a smart phone or an electronic pad.

Accordingly, a display device of the present disclosure may include an applied product or a set device of a final user's device including the LCM, the OLED module or the QD module as well as a display device in a narrow sense such as the LCM, the OLED module or the QD module.

According to circumstances, the LCM, the OLED module or the QD module having a display panel and a driving unit may be expressed as "a display device", and an electronic apparatus of a complete product including the LCM, the OLED module or the QD module may be expressed as "a set device." For example, a display device in a narrow sense may include a display panel of a liquid crystal, an organic light emitting diode or a quantum dot and a source printed circuit board (PCB) of a control unit for driving the display panel, and a set device may further include a set PCB of a set control unit electrically connected to the source PCB for controlling the entire set device.

The display panel of the present disclosure may include all kinds of display panels such as a liquid crystal display panel, an organic light emitting diode display panel, a quantum dot display panel and an electroluminescent display panel. The display panel of the present disclosure is not limited to a specific display panel of a bezel bending having a flexible substrate for an organic light emitting diode display panel and a lower back plate supporter. A shape or a size of the display panel for the display device of the present disclosure is not limited thereto.

For example, when the display panel is an organic light emitting diode display panel, the display panel may include a plurality of gate lines, a plurality of data lines and a subpixel in a crossing region of the plurality of gate lines and the plurality of data lines. The display panel may include an array having a thin film transistor of an element for selectively applying a voltage to each subpixel, an emitting element layer on the array and an encapsulating substrate or an encapsulation part covering the emitting element layer. The encapsulation part may protect the thin film transistor and the emitting element layer from an external impact and may prevent or at least reduce penetration of a moisture or oxygen into the emitting element layer. In addition, the emitting element layer on the array may include an inorganic light emitting layer, for example, a nano-sized material layer or a quantum dot.

The thin film transistor of the present disclosure may include one of an oxide thin film transistor, an amorphous silicon thin film transistor, and a low temperature polycrystalline silicon thin film transistor.

Features of various embodiments of the present disclosure may be partially or entirely coupled to or combined with each other. They may be linked and operated technically in various ways as those skilled in the art may sufficiently understand. The aspects may be carried out independently of or in association with each other in various combinations.

Hereinafter, a display device according to various example embodiments of the present disclosure where an area of a non-display area is reduced and a narrow bezel is obtained by forming a plurality of power supply lines having the same layer and the same material as a bridge pattern for sensing a touch to overlap an auxiliary circuit unit will be described in detail with reference to the accompanying drawings.

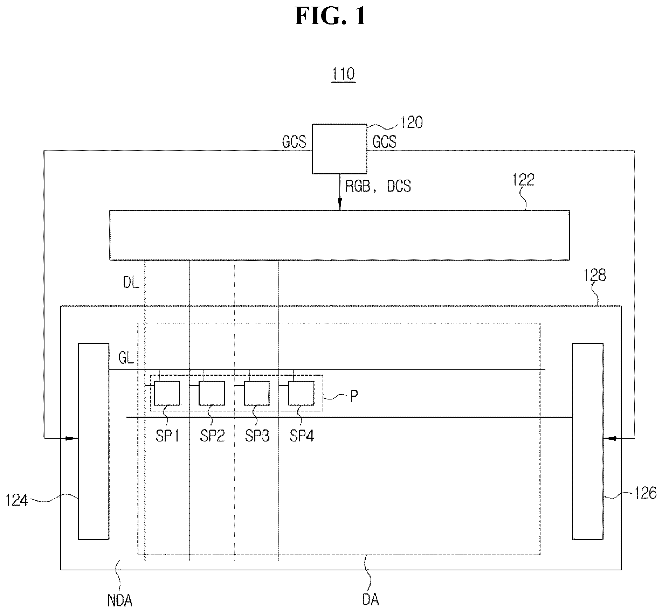

FIG. 1 is a view showing a display device according to an embodiment of the present disclosure. Although the display device may be an organic light emitting diode (OLED) display device, it is not limited thereto. For example, the display device may be a micro light emitting diode (LED) display device or a mini light emitting diode (LED) display device.

In FIG. 1, a display device 110 according to an embodiment of the present disclosure includes a timing controlling unit 120 (e.g., a circuit), a data driving unit 122 (e.g., a circuit), first and second gate driving units 124 and 126 (e.g., circuits) and a display panel 128.

The timing controlling unit 120 generates an image data RGB, a data control signal DCS and a gate control signal GCS using an image signal and a plurality of timing signals including a data enable signal, a horizontal synchronization signal, a vertical synchronization signal and a clock signal transmitted from an external system such as a graphic card or a television system. The timing controlling unit 120 transmits the image data RGB and the data control signal DCS to the data driving unit 122, and transmits the gate control signal GCS to the first and second gate driving units 124 and 126.

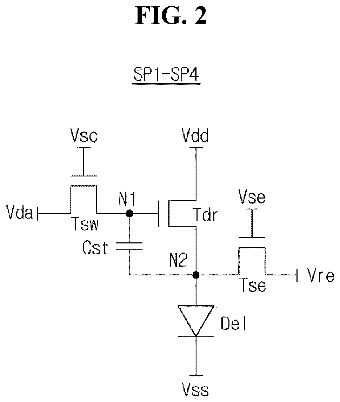

The data driving unit 122 generates a data signal (a data voltage) Vda (of FIG. 2) using the image data RGB and the data control signal DCS transmitted from the timing controlling unit 120 and transmits the data signal Vda to a data line DL of the display panel 128.

The first and second gate driving units 124 and 126 generate a gate signal (a gate voltage) Vsc and Vse (of FIG. 2) using the gate control signal GCS transmitted from the timing controlling unit 120 and applies the gate signal Vsc and Vse to a gate line GL of the display panel 128.

The first and second gate driving units 124 and 126 may have a gate in panel (GIP) type to be formed in a non-display area NDA of a substrate of the display panel 128 having the gate line GL, the data line DL and a pixel P.

Although the first and second gate driving units 124 and 126 are disposed in both side portions of the display panel 128 in the embodiment of FIG. 1, one gate driving unit may be disposed in one side portion of the display panel 128 in another embodiment.

The display panel 128 includes a display area DA at a central portion thereof and a non-display area NDA surrounding the display area DA. The display panel 128 displays an image using the gate signal Vsc and Vse and the data signal Vda. Hereinafter, the gate signal Vsc and Vse are referred to as the scan signal Vsc and sensing signal Vse respectively. For displaying an image, the display panel 128 includes a plurality of pixels P, a plurality of gate lines GL and a plurality of data lines DL in the display area DA.

Each of the plurality of pixels P includes first, second, third and fourth subpixels SP1, SP2, SP3 and SP4, and the gate line GL and the data line DL cross each other to define the first, second, third and fourth subpixels SP1, SP2, SP3 and SP4. Each of the first, second, third and fourth subpixels SP1, SP2, SP3 and SP4 is connected to the gate line GL and the data line DL. For example, the first, second, third and fourth subpixels SP1, SP2, SP3 and SP4 may correspond to first, second, third and fourth colors, respectively, and the first, second, third and fourth colors may be red, green, blue and white colors, respectively.

Each of the first, second, third and fourth subpixels SP1, SP2, SP3 and SP4 may include a plurality of transistors such as a switching transistor Tsw (of FIG. 2), a driving transistor Tdr (of FIG. 2) and a sensing transistor Tse (of FIG. 2), a storage capacitor Cst (of FIG. 2) and a light emitting diode Del (of FIG. 2).

FIG. 2 is a circuit diagram showing a subpixel of a display device according to an embodiment of the present disclosure.

In FIG. 2, each of the first, second, third and fourth subpixels SP1, SP2, SP3 and SP4 of the display panel 128 of the display device 110 according to an embodiment of the present disclosure includes a switching transistor Tsw, a driving transistor Tdr, a sensing transistor Tse, a storage capacitor Cst and a light emitting diode Del.

Although each of the first, second, third and fourth subpixels SP1, SP2, SP3 and SP4 has a 3T1C structure having three transistors and one storage capacitor in the embodiment of FIG. 2, each of the first, second, third and fourth subpixels SP1, SP2, SP3 and SP4 may have one of a 6T1C structure having six transistors and one storage capacitor, a 7T1C structure having seven transistors and one storage capacitor and a 8T1C structure having eight transistors and one storage capacitor in another embodiment.

Although the switching transistor Tsw, the driving transistor Tdr and the sensing transistor Tse may have a negative type (N type) in the embodiment of FIG. 2, at least one of the switching transistor Tsw, the driving transistor Tdr and the sensing transistor Tse may have a positive type (P type) in another embodiment.

The switching transistor Tsw is switched according to a scan signal Vsc to transmit a data signal Vda to a first node N1.

A gate electrode of the switching transistor Tsw is connected to the gate line GL to receive the scan signal Vsc, a drain electrode of the switching transistor Tsw is connected to the data line DL to receive the data signal Vda, and a source electrode of the switching transistor Tsw is connected to the first node N1.

The driving transistor Tdr is switched according to a voltage of the first node N1 to transmit a high level signal (high level voltage) Vdd to a second node N2.

A gate electrode of the driving transistor Tdr is connected to the first node N1, a drain electrode of the driving transistor Tdr is connected to a high level power line to receive the high level signal Vdd, and a source electrode of the driving transistor Tdr is connected to the second node N2.

The sensing transistor Tse is switched according to a sensing signal (sensing voltage) Vse to transmit a reference signal (reference voltage) Vre to the second node N2 or transmit a voltage of the second node N2 to a reference line.

A gate electrode of the sensing transistor Tse is connected to the gate line GL to receive the sensing signal Vse, a drain electrode of the sensing transistor Tse is connected to the reference line to receive the reference signal Vre or transmit a voltage of the second node N2 to the reference line, and a source electrode of the sensing transistor Tse is connected to the second node N2.

The storage capacitor Cst keeps the data signal Vda supplied to the first node N1 for one frame and stores a threshold voltage Vth of the driving transistor Tdr.

A first capacitor electrode of the storage capacitor Cst is connected to the first node N1, and a second capacitor electrode of the storage capacitor Cst is connected to the second node N2.

The light emitting diode Del emits a light of a luminance proportional to a current of the driving transistor Tdr.

An anode of the light emitting diode Del is connected to the second node N2, and a cathode of the light emitting diode Del is connected to a low level power line to receive a low level signal (low level voltage) Vss.

The source electrode of the switching transistor Tsw, the gate electrode of the driving transistor Tdr and the first capacitor electrode of the storage capacitor Cst constitute the first node N1, and the source electrode of the driving transistor Tdr, the source electrode of the sensing transistor Tse, the second capacitor electrode of the storage capacitor Cst and anode of the light emitting diode Del constitute the second node N2.

The light emitting diode Del may display an image having a luminance corresponding to the image data RGB according to a driving of subpixel circuits of the first, second, third and fourth subpixels SP1, SP2, SP3 and SP4.

A cross-sectional structure of each subpixel SP1, SP2, SP3 and SP4 of the display panel 128 of the display device 110 will be illustrated with reference to a drawing.

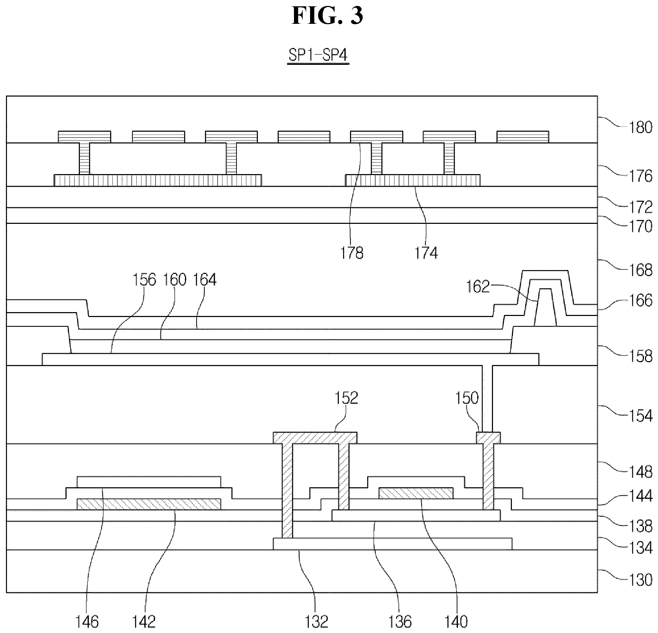

FIG. 3 is a cross-sectional view showing a subpixel of a display panel of a display device according to an embodiment of the present disclosure.

In FIG. 3, a light shielding pattern 132 is disposed in each of the first, second, third and fourth subpixels SP1, SP2, SP3 and SP4 on a substrate 130, and a first buffer layer 134 is disposed on the light shielding pattern 132 over the entire substrate 130.

The light shielding pattern 132 may block a light incident from a lower portion of the substrate 130. For example, the light shielding pattern 132 may have a single layer or a multiple layer of a metallic material such as molybdenum (Mo), aluminum (Al), chromium (Cr), gold (Au), titanium (Ti), nickel (Ni), neodymium (Nd), copper (Cu) and an alloy thereof.

The first buffer layer 134 may block a moisture or an oxygen permeating from an exterior. For example, the first buffer layer 134 may have a single layer or a multiple layer of an inorganic insulating material such as silicon oxide (SiO2) and silicon nitride (SiNx).

A semiconductor layer 136 is disposed on the first buffer layer 134 corresponding to the light shielding pattern 132, and a gate insulating layer 138 is disposed on the semiconductor layer 136 over the entire substrate 130.

The semiconductor layer 136 includes a channel region not doped with an impurity at a central portion thereof and source and drain regions doped with an impurity at both side portions of the channel region. For example, the semiconductor layer 136 may include a polycrystalline semiconductor material such as polycrystalline silicon or an oxide semiconductor material such as indium gallium zinc oxide (IGZO), zinc oxide (ZnO), tin oxide (SnO2), copper oxide (Cu2O), nickel oxide (NiO), indium tin zinc oxide (ITZO) and indium aluminum zinc oxide (IAZO).

For example, the gate insulating layer 138 may have a single layer or a multiple layer of an inorganic insulating material such as silicon oxide (SiO2) and silicon nitride (SiNx).

A gate electrode 140 is disposed on the gate insulating layer 138 corresponding to the channel region of the semiconductor layer 136, a first capacitor electrode 142 separated from the gate electrode 140 is disposed on the gate insulating layer 138, and a first interlayer insulating layer 144 is disposed on the gate electrode 140 and the first capacitor electrode 142.

The gate electrode 140 and the first capacitor electrode 142 may have the same layer and the same material as each other. For example, the gate electrode 140 and the first capacitor electrode 142 may have a single layer or a multiple layer of a metallic material such as molybdenum (Mo), aluminum (Al), chromium (Cr), gold (Au), titanium (Ti), nickel (Ni), neodymium (Nd), copper (Cu) and an alloy thereof.

For example, the first interlayer insulating layer 144 may have a single layer or a multiple layer of an inorganic insulating material such as silicon oxide (SiO2) and silicon nitride (SiNx).

A second capacitor electrode 146 is disposed on the first interlayer insulating layer 144 corresponding to the first capacitor electrode 142, and a second interlayer insulating layer 148 is disposed on the second capacitor electrode 146 over the entire substrate 130.

For example, the second capacitor electrode 146 may have a single layer or a multiple layer of a metallic material such as molybdenum (Mo), aluminum (Al), chromium (Cr), gold (Au), titanium (Ti), nickel (Ni), neodymium (Nd), copper (Cu) and an alloy thereof.

For example, the second interlayer insulating layer 148 may have a single layer or a multiple layer of an inorganic insulating material such as silicon oxide (SiO2) and silicon nitride (SiNx).

The first capacitor electrode 142, the first interlayer insulating layer 144 and the second capacitor electrode 146 may constitute the storage capacitor Cst.

A source electrode 150 and a drain electrode 152 spaced apart from each other are disposed on the second interlayer insulating layer 148, and a planarizing layer 154 is disposed on the source electrode 150 and the drain electrode 152 over the entire substrate 130.

The source electrode 150 and the drain electrode 152 are connected to the source region and the drain region, respectively, of the semiconductor layer 136 through contact holes in the second interlayer insulating layer 148, the first interlayer insulating layer 144 and the gate insulating layer 138, and the drain electrode 152 is connected to the light shielding pattern 132 through a contact hole in the second interlayer insulating layer 148, the first interlayer insulating layer 144, the gate insulating layer 138 and the first buffer layer 134.

The source electrode 150 and the drain electrode 152 may have the same layer and the same material as each other. For example, the source electrode 150 and the drain electrode 152 may have a single layer or a multiple layer of a metallic material such as molybdenum (Mo), aluminum (Al), chromium (Cr), gold (Au), titanium (Ti), nickel (Ni), neodymium (Nd), copper (Cu) and an alloy thereof.

For example, the planarizing layer 154 may have a single layer or a multiple layer of an organic insulating material such as photoacryl and benzocyclobutene (BCB).

The semiconductor layer 136, the gate electrode 140, the source electrode 150 and the drain electrode 152 may constitute the driving transistor Tdr.

A first electrode 156 is disposed on the planarizing layer 154 corresponding to the source electrode 150, and a bank layer 158 is disposed on the first electrode 156.

The first electrode 156 is connected to the source electrode 150 through a contact hole in the planarizing layer 154.

For example, the first electrode 156 may be an anode and may have a single layer or a multiple layer of a transparent conductive material such as indium tin oxide (ITO) and indium zinc oxide (IZO) or a half-transmissive or opaque metallic material such as aluminum (Al), silver (Ag), copper (Cu), lead (Pb), molybdenum (Mo), titanium (Ti) and an alloy thereof.

The bank layer 158 covers an edge portion of the first electrode 156 and has an opening exposing a central portion of the first electrode 156.

For example, the bank layer 158 may have a single layer or a multiple layer of an organic insulating material such as photoacryl and benzocyclobutene (BCB).

A spacer 162 is disposed on the bank layer 158, an emitting layer 160 is disposed on the first electrode 156, and a second electrode 164 is disposed on the emitting layer 160 and the spacer 162 over the entire substrate 130.

For example, the spacer 162 may have a single layer or a multiple layer of an organic insulating material such as photoacryl and benzocyclobutene (BCB).

The emitting layer 160 contacts the first electrode 156 exposed through the opening of the bank layer 158 and a side surface of the opening of the bank layer 158.

The emitting layer 160 may include a hole assisting layer such as a hole injecting layer and a hole transporting layer, an emitting material layer and an electron assisting layer such as an electron transporting layer and an electron injecting layer.

For example, the second electrode 164 may be a cathode and may have a single layer or a multiple layer of a transparent conductive material such as indium tin oxide (ITO) and indium zinc oxide (IZO) or an opaque metallic material such as aluminum (Al), silver (Ag), copper (Cu), lead (Pb), magnesium (Mg), molybdenum (Mo), titanium (Ti) and an alloy thereof.

The first electrode 156, the emitting layer 160 and the second electrode 164 may constitute the light emitting diode Del.

A first encapsulating layer 166, a second encapsulating layer 168 and a third encapsulating layer 170 for preventing a permeation of a moisture are sequentially disposed on the second electrode 164 over the entire substrate 130.

For example, the first encapsulating layer 166 and the third encapsulating layer 170 may have a single layer or a multiple layer of an inorganic insulating material such as silicon oxide (SiO2) and silicon nitride (SiNx), and the second encapsulating layer may include an organic insulating material such as acryl resin, epoxy resin, phenolic resin, polyamide resin and polyimide resin.

A second buffer layer 172 is disposed on the third encapsulating layer 170 over the entire substrate 130, and a plurality of bridge patterns 174 spaced apart from each other are disposed on the second buffer layer 172.

The second buffer layer 172 may block a moisture or an oxygen permeating from an exterior. For example, the second buffer layer 172 may have a single layer or a multiple layer of an inorganic insulating material such as silicon oxide (SiO2) and silicon nitride (SiNx).

For example, the plurality of bridge patterns 174 may have a single layer or a multiple layer of a transparent conductive material such as indium tin oxide (ITO) and indium zinc oxide (IZO) or a half-transmissive or opaque metallic material such as aluminum (Al), silver (Ag), copper (Cu), lead (Pb), magnesium (Mg), molybdenum (Mo), titanium (Ti) and an alloy thereof.

A third interlayer insulating layer 176 is disposed on the plurality of bridge patterns 174 over the entire substrate 130, a plurality of sensor patterns 178 spaced apart from each other are disposed on the third interlayer insulating layer 176, and a protecting layer 180 is disposed on the plurality of sensor patterns 178 over the entire substrate 130.

The plurality of sensor patterns 178 are connected to the plurality of bridge patterns 174 through contact holes in the third interlayer insulating layer 176. The plurality of sensor patterns 178 may sense a touch by detecting a change of a capacitance of the plurality of sensor patterns 178 according to the touch.

For example, the third interlayer insulating layer 176 may have a single layer or a multiple layer of an inorganic insulating material such as silicon oxide (SiO2) and silicon nitride (SiNx) or an organic insulating material such as photoacryl and benzocyclobutene (BCB).

For example, the plurality of sensor patterns 178 may have a single layer or a multiple layer of a transparent conductive material such as indium tin oxide (ITO) and indium zinc oxide (IZO) or a half-transmissive or opaque metallic material such as aluminum (Al), silver (Ag), copper (Cu), lead (Pb), magnesium (Mg), molybdenum (Mo), titanium (Ti) and an alloy thereof.

For example, the protecting layer 180 may have a single layer or a multiple layer of an inorganic insulating material such as silicon oxide (SiO2) and silicon nitride (SiNx) or an organic insulating material such as photoacryl and benzocyclobutene (BCB).

A reference supply line, a high level supply line and a low level supply line having the same layer and the same material as the plurality of bridge patterns 174 may be disposed in the non-display area NDA of the display panel 128.

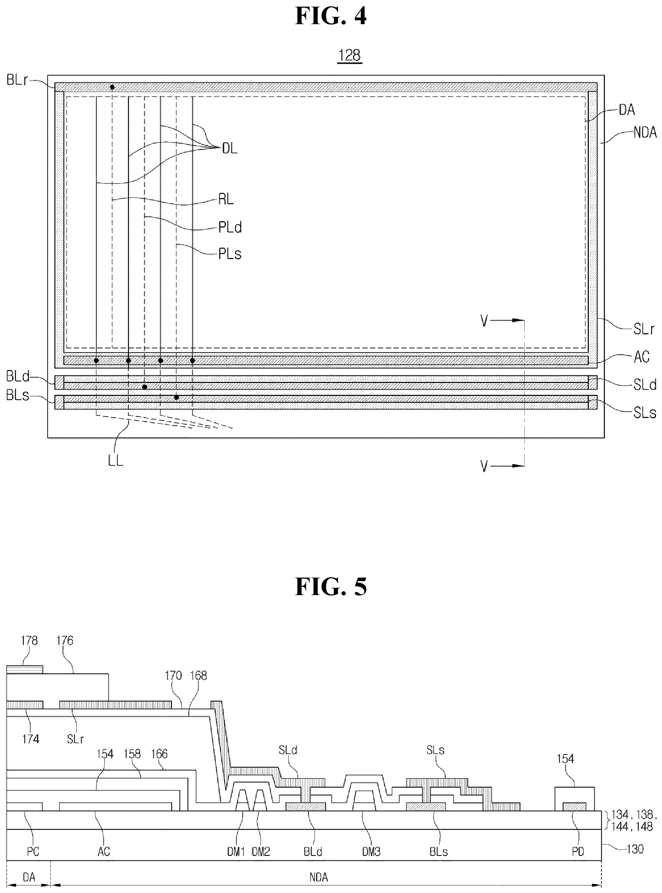

FIG. 4 is a plan view showing a display panel of a display device according to an embodiment of the present disclosure, and FIG. 5 is a cross-sectional view taken along a line V-V of FIG. 4.

In FIG. 4, the display panel 128 of the display device 110 according to an embodiment of the present disclosure has the display area DA where the plurality of pixels P are disposed and the non-display area NDA surrounding the display area DA.

Each of the plurality of pixels P includes the first, second, third and fourth subpixels SP1, SP2, SP3 and SP4, and each of the first, second, third and fourth subpixels SP1, SP2, SP3 and SP4 is connected to the gate line GL (not illustrated in FIG.4), the data line DL crossing the gate line GL, a reference power line RL crossing the gate line GL and parallel to the data line DL, a high level power line PLd and a low level power line PLs.

The data line DL is connected to a link line LL, and the link line LL is connected to the data driving unit 122 (not illustrated in FIG.4).

As a result, each of the first, second, third and fourth subpixels SP1, SP2, SP3 and SP4 includes a pixel circuit unit PC (of FIG. 5) such as the switching transistor Tsw, the driving transistor Tdr, the sensing transistor Tse and the storage capacitor Cst. The pixel circuit unit PC receives the gate signal through the gate line GL, the data signal through the data line DL, the reference signal Vre through the reference power line RL, the high level signal Vdd through the high level power line PLd and the low level signal through the low level power line PLs to drive the light emitting diode Del.

A plurality of power base lines and a plurality of power supply lines are disposed in the non-display area NDA. The plurality of power base lines include a reference base line BLr, a high level base line BLd and a low level base line BLs, and the plurality of power supply lines include a reference supply line SLr, a high level supply line SLd and a low level supply line SLs.

The reference base line BLr connected to the reference power line RL is disposed in the non-display area NDA at an upper portion of the display area DA, and an auxiliary circuit unit AC is disposed in the non-display area NDA at a lower portion of the display area DA.

For example, the reference base line BLr may have a bar shape parallel to the gate line GL.

For example, the auxiliary circuit unit AC may include at least one of a plurality of multiplexers and a plurality of electrostatic discharge circuits, and each of the plurality of multiplexers and the plurality of electrostatic discharge circuits may include a transistor, a diode and a capacitor.

The high level base line BLd connected to the high level power line PLd is disposed in the non-display area NDA at a lower portion of the auxiliary circuit unit AC, and the low level base line BLs connected to the low level power line PLs is disposed in the non-display area NDA at a lower portion of the high level base line BLd.

For example, each of the high level base line BLd and the low level base line BLs may have a bar shape parallel to the gate line GL.

The reference supply line SLr connected to the reference base line BLr is disposed over the reference base line BLr and the auxiliary circuit unit AC, and is disposed in the non-display area NDA at upper, lower, left and right portions of the display area DA.

For example, the reference supply line SLr may have a rectangular ring shape surrounding the display area DA.

The high level supply line SLd connected to the high level base line BLd is disposed over the high level base line BLd of the non-display area NDA at a lower portion of the display area DA. The low level supply line SLs connected to the low level base line BLs is disposed over the low level base line BLs of the non-display area NDA at a lower portion of the display area DA.

For example, each of the high level supply line SLd and the low level supply line SLs may have a bar shape parallel to the gate line GL. Lengths of the high level supply line SLd and the low level supply line SLs along a direction parallel to the gate line GL may be smaller than lengths of the high level base line BLd and the low level base line BLs, respectively.

Each of the gate line GL, the reference power line RL, the high level power line PLd, the low level power line PLs and the link line LL may have the same layer and the same material as the gate electrode 140. Each of the data line DL, the reference base line BLr, the high level base line BLd and the low level base line BLs may have the same layer and the same material as the source electrode 150 and the drain electrode 152. Each of the reference supply line SLr, the high level supply line SLd and the low level supply line SLs may have the same layer and the same material as the plurality of bridge patterns 174.

The reference base line BLr is connected to the reference power line RL through a contact hole in the reference base line BLr. The reference base line BLr may supply the reference signal from an upper portion of the display area DA through the reference supply line SLr surrounding the display area DA.

The data line DL may be connected to the link line LL through a contact hole in the auxiliary circuit unit AC.

The high level base line BLd may be connected to the high level power line PLd through a contact hole in the high level base line BLd, and the low level base line BLs may be connected to the low level power line PLs through a contact hole in the low level base line BLs.

The reference supply line SLr may overlap the auxiliary circuit unit AC in the non-display area NDA at a lower portion of the display area DA. An area of the non-display area NDA may be reduced or minimized by disposing a region where the reference supply line SLr and the reference power line RL are connected to each other in the non-display area NDA at an upper portion of the display area DA.

The reference supply line SLr of the non-display area NDA at left and right portions of the display area DA may overlap the first and second gate driving units 124 and 126.

The reference supply line SLr may be connected to the reference base line BLr through a contact hole in the reference base line BLr. The high level supply line SLd may be connected to the high level base line BLd through a contact hole in the high level base line BLd. The low level supply line SLs may be connected to the low level base line BLs through a contact hole in the low level base line BLs.

In FIG. 5, the first buffer layer 134, the gate insulating layer 138, the first interlayer insulating layer 144 and the second interlayer insulating layer 148 are sequentially disposed in the display area DA and the non-display area NDA on the substrate 130.

The pixel circuit unit PC including the switching transistor Tsw, the driving transistor Tdr, the sensing transistor Tse and the storage capacitor Cst is disposed on the second interlayer insulating layer 148 of each subpixel SP1 to SP4 of the display area DA, and the auxiliary circuit unit AC including at least one of the plurality of multiplexers and the plurality of electrostatic discharge circuits is disposed on the second interlayer insulating layer 148 of the non-display area NDA at a lower portion of the display area DA.

The planarizing layer 154 and the bank layer 158 are sequentially disposed on the pixel circuit unit PC and the auxiliary circuit unit AC.

First, second and third dams DM1, DM2 and DM3 are disposed on the second interlayer insulating layer of the non-display area NDA surrounding the display area DA. The first dams DM1 and second dams DM2 are disposed between the auxiliary circuit unit AC and the high level base line BLd, and the third dam DM3 is disposed between the high level base line BLd and the low level base line BLs. The high level base line BLd is disposed on the second interlayer insulating layer 148 of the non-display area NDA between the second and third dams DM2 and DM3. The low level base line BLs is disposed on the second interlayer insulating layer 148 of the non-display area NDA at a lower portion of the third dam DM3. A pad PD is disposed on the second interlayer insulating layer 148 of the non-display area NDA at a lower portion of the low level base line BLs.

The planarizing layer 154 is disposed on the pad PD.

The first, second and third dams DM1, DM2 and DM3 prevents an overflow of the second encapsulating layer 168 in a subsequent process. Each of the first, second and third dams DM1, DM2 and DM3 may include a lower layer having the same layer and the same material as the planarizing layer 154 and an upper layer having the same layer and the same material as the bank layer 158.

The upper layer of the first, second and third dams DM1, DM2 and DM3 may have a thickness greater than a thickness of the bank layer 158 using a half transmissive mask.

Although the display device 110 includes the first, second and third dams DM1, DM2 and DM3 in the embodiment of FIG. 5, the display device may include one dam or four or more dams in another embodiment.

Each of the high level base line BLd and the low level base line BLs of the non-display area NDA may have the same layer and the same material as the source electrode 150 and the drain electrode 152 of the display area DA.

The first encapsulating layer 166, the second encapsulating layer 168 and the third encapsulating layer 170 are sequentially disposed on the bank layer 158 corresponding to the pixel circuit unit PC of the display area DA and the auxiliary circuit unit AC of the non-display area NDA. The first encapsulating layer 166 and the third encapsulating layer 170 are sequentially disposed on the first, second and third dams DM1, DM2 and DM3, the high level base line BLd and the low level base line BLs of the non-display area NDA.

As a result, the first encapsulating layer 166 and the third encapsulating layer 170 without the second encapsulating layer 168 are sequentially disposed on the first, second and third dams DM1, DM2 and DM3, the high level base line BLd and the low level base line BLs.

The plurality of bridge patterns 174 are disposed on the third encapsulating layer 170 corresponding to the pixel circuit unit PC of the display area DA. The reference supply line SLr is disposed on the third encapsulating layer 170 corresponding to the auxiliary circuit unit AC of the non-display area NDA. The high level supply line SLd is disposed on the third encapsulating layer 170 corresponding to the high level base line BLd. The low level supply line SLs is disposed on the third encapsulating layer 170 corresponding to the low level base line BLs.

There can also be a second buffer layer 172 (for example, similar to Fig. 3) disposed between the third encapsulating layer 170 and the plurality of bridge patterns 174.

The reference supply line SLr may overlap the auxiliary circuit unit AC and may be connected to the reference base line BLr through a contact hole in the first encapsulating layer 166 and the third encapsulating layer 170 (not illustrated in figure).

The high level supply line SLd may be connected to the high level base line BLd through a contact hole in the first encapsulating layer 166 and the third encapsulating layer 170. The low level supply line SLs may be connected to the low level base line BLs through a contact hole in the first encapsulating layer 166 and the third encapsulating layer 170.

The reference supply line SLr, the high level supply line SLd and the low level supply line SLs may have the same layer and the same material as the plurality of bridge patterns 174.

The third interlayer insulating layer 176 is disposed on the plurality of bridge patterns 174 of the display area DA, and the plurality of sensor patterns 178 are disposed on the third interlayer insulating layer 176 corresponding to the plurality of bridge patterns 174.

Although the reference supply line SLr among the plurality of power supply lines overlaps the auxiliary circuit unit AC in the embodiment of FIG. 5, the high level supply line SLd or the low level supply line SLs among the plurality of power supply lines may overlap the auxiliary circuit unit AC in another embodiment.

Consequently, in the display device 110 according to an embodiment of the present disclosure, since at least one of the plurality of power supply lines overlapping the auxiliary circuit unit AC and having the same layer and the same material as the plurality of bridge patterns 174 is disposed over the auxiliary circuit unit AC of the non-display area NDA, an area of the non-display area NDA is reduced, a narrow bezel is obtained, and a fabrication process is optimized.

## Claims

1. A display device (110), comprising:
a display panel (128) having a display area (DA) and a non-display area (NDA) at a periphery of the display area (DA);
a plurality of gate lines (GL) and a plurality of data lines (DL) in the display area (DA), the plurality of gate lines (GL) and the plurality of data lines (DL) crossing each other to define a plurality of subpixels (SP1, ..., SP4);
a pixel circuit unit (PC) in each of the plurality of subpixels (SP1, ..., SP4);
an auxiliary circuit unit (AC) in the non-display area (NDA); and
at least one power supply line (SLr, SLd, SLs) in the non-display area (NDA) and overlapping the auxiliary circuit unit (AC).

2. The display device (110) of claim 1, further comprising:
at least one power base line (BLr, BLd, BLs) in the non-display area (NDA) and connected to the at least one power supply line (SLr, SLd, SLs); and
a plurality of bridge patterns (174) and a plurality of sensor patterns (178) in the display area (DA) for sensing a touch.

3. The display device (110) of claim 2, wherein the at least one power supply line (SLr, SLd, SLs) has a same layer and a same material as the plurality of bridge patterns (174).

4. The display device (110) of claim 2 or 3, wherein the auxiliary circuit unit (AC) includes at least one of a plurality of multiplexers and a plurality of electrostatic discharge circuits.

5. The display device (110) of any of claims 2 to 4, wherein the at least one power base line (BLr, BLd, BLs) includes a reference base line (BLr) in the non-display area (NDA) at an upper portion of the display area (DA), a high level base line (BLd) in the non-display area (NDA) at a lower portion of the display area (DA) and a low level base line (BLs) in the non-display area (NDA) at a lower portion of the high level base line (BLd), and
wherein the at least one power supply line (SLr, SLd, SLs) includes a reference supply line (SLr) overlapping the auxiliary circuit unit (AC) and connected to the reference base line (BLr), a high level supply line (SLd) connected to the high level base line (BLd) and a low level supply line (SLs) connected to the low level base line (BLs).

6. The display device (110) of claim 5, wherein the pixel circuit unit (PC) includes at least one thin film transistor,
wherein the at least one thin film transistor includes a semiconductor layer (136), a gate insulating layer (138) on the semiconductor layer (136), a gate electrode (140) on the gate insulating layer (138) corresponding to the semiconductor layer (136), first and second interlayer insulating layers (144, 148) on the gate electrode (140) and a source electrode (150) and a drain electrode (152) on the second interlayer insulating layer (148), and
wherein the reference base line (BLr), the high level base line (BLd) and the low level base line (BLs) have a same layer and a same material as the source electrode (150) and the drain electrode (152).

7. The display device (110) of claim 6, further comprising a plurality of reference power lines (RL), a plurality of high level power lines (PLd) and a plurality of low level power lines (PLs) spaced apart and parallel to the plurality of data lines (DL) and having a same layer and a same material as the gate electrode (140).

8. The display device (110) of claim 7, wherein the plurality of reference power lines (RL) are connected to the reference base line (BLr),
wherein the plurality of high level power lines (PLd) are connected to the high level base line (BLd), and
wherein the plurality of low level power lines (PLs) are connected to the low level base line (BLs).

9. The display device (110) of claim 7 or 8, wherein the reference supply line (SLr) and the plurality of reference power lines (RL) are connected to each other in the non-display area (NDA) at an upper portion of the display area (DA).

10. The display device (110) of any of claims 5 to 9, wherein first, second and third encapsulating layers (166, 168, 170) are disposed between the auxiliary circuit unit (AC) and the reference base line (BLr), and
wherein the first and third encapsulating layers (166, 170) are disposed between the high level base line (BLd) and the high level supply line (SLd) and between the low level base line (BLs) and the low level supply line (SLs).

11. The display device (110) of any of claims 5 to 10, further comprising first and second dams (DM1, DM2) between the auxiliary circuit unit (AC) and the high level base line (BLd) and a third dam (DM3) between the high level base line (BLd) and the low level base line (BLs).
